# EUROPÄISCHE PATENTSCHRIFT

(11) **EP 3 413 465 B1**
(45) Veröffentlichungstag und Bekanntmachung des Hinweises auf die Patenterteilung: **24.08.2022**
(21) Anmeldenummer: 18173629.9
(22) Anmeldetag: 22.05.2018
(51) Int. Cl.: H03K 17/975, H01H 13/52

(54) **BEDIENVORRICHTUNG ZUM BEDIENEN VON ZUMINDEST EINEM GERÄT EINES KRAFTFAHRZEUGS, MIT EINEM SEPARATEN FEDERELEMENT ALS ERDUNGSVERBINDUNG SOWIE KRAFTFAHRZEUG**
OPERATING DEVICE FOR OPERATING LEAST ONE DEVICE OF A MOTOR VEHICLE, WITH A SEPARATE SPRING ELEMENT AS EARTHING CONNECTION AND MOTOR VEHICLE
DISPOSITIF DE COMMANDE DESTINÉE À COMMANDER AU MOINS UN APPAREIL D'UN VÉHICULE AUTOMOBILE POURVU D'UN ÉLÉMENT SÉPARÉ EN TANT QUE RACCORDEMENT À LA TERRE AINSI QUE VÉHICULE AUTOMOBILE

(30) Priorität: 31.05.2017 DE 102017111919
(43) Veröffentlichungstag der Anmeldung: 12.12.2018
(73) Patentinhaber: Valeo Schalter und Sensoren GmbH, 74321 Bietigheim-Bissingen (DE)
(72) Erfinder: Schmitt, Martin, 96476 Bad Rodach (DE); Hentschel, Joachim, 96476 Bad Rodach (DE); Musat, Ciprian, 94046 Cedex, Creteil (FR)
(74) Vertreter: Pothmann, Karsten

(56) Entgegenhaltungen:
- CN-U- 204 465 499
- DE-A1- 2 347 722
- DE-A1-102014 104 324
- US-A- 3 842 230
- US-A- 4 458 293
- US-A- 4 584 444

## Beschreibung

Die Erfindung betrifft eine Bedienvorrichtung zum Bedienen von zumindest einem Gerät eines Kraftfahrzeugs. Die Bedienvorrichtung weist ein Bedienelement und eine Messeinheit auf, die eine erste Elektrode und eine zweite Elektrode aufweist. Abhängig von einer Betätigung des Bedienelements sind die beiden Elektroden relativ zueinander bewegbar. Abhängig von einem Abstand der ersten Elektrode und der zweiten Elektrode zueinander ist ein Wert eines physikalischen Parameters durch die Messeinheit erfassbar und in Abhängigkeit des Werts ist das Gerät bedienbar. Ferner betrifft die Erfindung ein Kraftfahrzeug.

Aus dem Stand der Technik sind insbesondere Bedienvorrichtungen, bei welchen eine Bedienung eines Geräts mittels kapazitiver Kraftmesser beziehungsweise Kraftsensor erfolgen kann, bereits hinlänglich bekannt. Beispielsweise offenbart die DE 10 2014 117 991 A1 einen solchen kapazitiven Kraftsensor. Der kapazitive Kraftsensor weist einen Grundflächenkörper, einen flächigen, elastisch nachgebenden Membrankörper und zwei beabstandet zueinander angeordnete Abstandhalter zwischen dem Grundflächenkörper und dem Membrankörper auf. Der Membrankörper stützt sich über die Abstandhalter an dem Grundflächenkörper ab und überragt wenigstens einen der Abstandhalter und bildet dabei ein freies Ende aus. Zwischen dem Membrankörper und dem Grundflächenkörper ist im Bereich zwischen dem Abstandhalter ein Hohlraum ausgebildet. Bei einer Krafteinwirkung auf den Membrankörper im Bereich zwischen den Abstandhaltern wird ein Durchbiegen des Membrankörpers gestattet und wobei an dem freien Ende eine erste Elektrode und an dem Grundflächenkörper eine zweite Elektrode vorgesehen ist. Die erste und die zweite Elektrode definieren einen Messkondensator mit sich mit der Krafteinwirkung ändernder Messkapazität. Des Weiteren definieren die erste und die zweite Elektrode ferner Mittel zur elektrischen Kontaktierung. Bei diesem Kraftsensor wird keine haptische Rückmeldung für einen Bediener erzeugt, so dass der Bediener im Unklaren ist, ob ein Gerät bedient worden ist.

Die US3842230 A offenbart eine Schaltvorrichtung mit einer ersten Elektrode, die auf der ebenen Oberfläche einer Isolierplatte angebracht ist, und einer zweiten Elektrode, die auf der ebenen Oberfläche der Isolierplatte mit einem ausreichenden Abstand von der ersten Elektrode gebildet ist, um von der ersten Elektrode zu isolieren, und mit einem anderen Durchmesser als den der ersten Elektrode. Die elektrische Verbindung beider Elektroden wird bewirkt, indem ein Ende einer Schraubenfeder mit einer der Elektroden verbunden bleibt und das andere Ende der Schraubenfeder beim Niederdrücken eines Aktuators zusammengedrückt wird.

Die DE 2347722 A1 offenbart einen Druckknopfschalter, welcher ein Tastenoberteil umfasst mit einer Aussparung und ein elastisches Element, das so vorgesehen ist, dass es die Aussparung des Tastenoberteils umgibt. Das elastische Element hat einen sich davon in der Richtung weg von der Aussparung des Tastenoberteils erstreckenden vorstehenden Abschnitt, und zumindest das Ende des vorstehenden Abschnitts ist aus leitfähigem Material gebildet. Ein Kontaktelement ist an einer Grundplatte gegenüber dem vorstehenden Abschnitt befestigt. Ein Halteelement hält das Tastenoberteil derart, dass der vorstehende Abschnitt des elastischen Elements normalerweise von dem Kontaktelement beabstandet ist, aber beim Niederdrücken des Tastenoberteils in das Kontaktelement eingreift.

Die US 4458293 A offenbart eine verbesserte kapazitive Tastatur mit mehreren Schalttasten, die jeweils eine minimale Kapazität definieren, wenn sie sich in einem vollständig ausgefahrenen Ruhezustand befindet, und eine maximale Kapazität, wenn sie gedrückt wird. Jede Schalttaste hat einen Kolbenmechanismus, der eine kapazitive Feder zusammendrückt, wenn die Taste gedrückt wird und die Feder freigibt, wenn die Taste losgelassen wird. Jede kapazitive Feder wird in Betriebsausrichtung über einem zugeordneten kapazitiven Pad befestigt, indem Bereiche der Basisspule der Feder an benachbarte plattierte Löcher in einer tragenden gedruckten Leiterplatte gelötet werden. Im Betrieb wird geschmolzenes Lot auf die Unterseite der gedruckten Leiterplatte aufgebracht und gelangt durch Kapillarwirkung durch die plattierten Löcher nach oben, um die Basisspule der Feder zu kontaktieren. Das ausgehärtete Lot hält die Feder in ihrer Betriebsposition auf der Leiterplatte und kontaktiert die Feder mit einem Ausgangsanschluss der Leiterplatte leitend.

Die US 4584444 A offenbart einen Tastaturschalter mit einem isolierenden Substrat, einer auf dem isolierenden Substrat gelegten ersten Elektrode, einer aus einer konischen Schraubenfeder gebildeten und der ersten Elektrode zugewandten zweiten Elektrode, einem auf der ersten Elektrode angeordneten Dielektrikum, einem auf der oberen Abschnitt der zweiten Elektrode und eine zwischen dem Knopf und der zweiten Elektrode angeordnete Gummikappe, um einer Bedienungsperson ein Schnappgefühl zu vermitteln, wenn der Knopf niedergedrückt wird und die Kapazität des Schalters einen gegebenen Wert überschreitet. Die Kapazität ändert sich mit der Änderung der Stirnfläche, die sich im wesentlichen proportional zur Eindrücktiefe des Knopfes ändert. Der Schalter ist für einen Schaltvorgang kapazitiv gekoppelt und das Schnappgefühl wird dem Bediener gegeben, wenn die Kapazität den gegebenen Wert überschreitet.

Die CN204465499 U offenbart einen kapazitiven Induktionsschlüsselschalter. Der kapazitive Induktions-Tastenschalter umfasst eine Tastenkappe, eine Leitungssäule, einen Rahmen und eine kapazitive Induktionseinheit; die Tastenkappe ist auf der Bleisäule abgedeckt, der Rahmen besteht aus einem Bleirohr, die Bleisäule ist teilweise in das Bleirohr eingeführt, die Bleisäule bewegt sich relativ zum Rahmen hin und her, die Kapazitätsinduktionseinheit besteht aus einer ersten Elektrodenplatte und einer zweiten Elektrode Platte, die in Abständen relativ miteinander gekoppelt sind, die erste Elektrodenplatte umfasst einen Körperteil und einen elastischen Teil, der Körperteil und die zweite Elektrode sind getrennt und relativ an der Außenseite des Leitungsrohrs angeordnet, der elastische Teil ist hülsenförmig an der Außenseite der Bleisäule und des Bleischlauchs angeordnet, liegt das obere Ende des elastischen Teils an der Bleisäule an und das untere Ende des elastischen Teils ist fest mit dem Körperteil verbunden. Der bereitgestellte kapazitive Induktionsschlüsselschalter hat die Vorteile einer hohen Zuverlässigkeit und geringen Kosten. Die Erfindung offenbart ferner eine Tastatur, die den Kapazitätsinduktions-Tastenknopf verwendet.

Die DE102014104324 A1 offenbart ein Bedienelement, aufweisend eine Blende, mit wenigstens einer elastischen Schicht, die eine unter der Einwirkung einer Betätigungskraft nachgebende Betätigungsflaeche definiert und mit einem auf der der Betätigungsfläche abgewandten Seite der elastischen Schicht angeordneten und an die elastische Schicht angrenzenden Abstützsteil; einen unter der elastischen Schicht angeordneten Kraftsensor zur Messung der auf die Betätigungsfläche einwirkenden Betätigungskraft; einen Stössel zwischen der elastischen Schicht und dem Kraftsensor und zur Übertragung der Betätigungskraft auf den Kraftsensor; eine Platine, auf der der Kraftsensor angeordnet ist, wobei sich die Blende auf der Platine in dem den Kraftsensor umgebenden Bereich der Platine über das Abstützteil abstützt.

Aufgabe der vorliegenden Erfindung ist es, eine Bedienvorrichtung sowie ein Kraftfahrzeug zu schaffen, welche beziehungsweise welches bauteilreduziert ausgebildet ist und einen Wert eines physikalischen Parameters genauer erfassen kann.

Diese Aufgabe wird durch eine Bedienvorrichtung sowie durch ein Kraftfahrzeug gemäß den unabhängigen Ansprüchen gelöst.

Ein Aspekt der Erfindung betrifft eine Bedienvorrichtung zum Bedienen von zumindest einem Gerät eines Kraftfahrzeugs. Die Bedienvorrichtung weist ein Bedienelement und eine Messeinheit auf, die eine erste Elektrode und eine zweite Elektrode aufweist. Abhängig von einer Betätigung des Bedienelements sind die beiden Elektroden zueinander bewegbar. Abhängig von einem Abstand der ersten Elektrode und der zweiten Elektrode zueinander ist ein Wert eines physikalischen Parameters durch die Messeinheit erfassbar. In Abhängigkeit des Werts ist das Gerät bedienbar.

Die Bedienvorrichtung weist ein Koppelelement auf, welches mit dem Bedienelement und mit der ersten Elektrode bewegungsgekoppelt ist. Die Bedienvorrichtung weist eine Trägerplatte auf, auf welcher die zweite Elektrode ausgebildet ist, und weist einen Erdungskontakt einer Erdungsverbindung zum Erden der ersten Elektrode auf der Trägerplatte auf. Die Erdungsverbindung weist ein zum Erdungskontakt separates Federelement auf, welches bei den durch die Relativbewegungen zwischen den Elektroden auftretenden unterschiedlichen Abständen jeweils sowohl mit dem Erdungskontakt und der ersten Elektrode kontaktiert ist. Dies hat den Vorteil, da das Federelement in sich längenveränderlich ist, dass bei einer Relativbewegung, insbesondere einer Entfernung der beiden Elektroden das Federelement den Kontakt mit der ersten Elektrode und dem Erdungskontakt aufgrund der Längenveränderung aufrechterhält. Dadurch kann besonders zuverlässig und auf einfache Art und Weise die Erdung der ersten Elektrode stets aufrechterhalten werden. Es kann auch besonders zuverlässig ein Wert des physikalischen Parameters, welcher insbesondere eine Kapazität beziehungsweise eine Induktivität sein kann, erfasst werden, wodurch dann das Gerät bedienbar. Es kann auch besonders bauteilreduziert die Erdung der ersten Elektrode insbesondere bei den unterschiedlichen Relativpositionen realisiert werden, da durch das eine Federelement die Erdung in den verschiedenen Relativpositionen durchgehend realisiert ist.

Gemäß einer weiteren vorteilhaften Ausgestaltungsform kann die Trägerplatte als eine Leiterplatte der Bedienvorrichtung ausgebildet sein. Insbesondere kann dadurch besonders bauteilreduziert die Bedienvorrichtung hergestellt werden, da somit elektrische Verbindungen zur Trägerplatte hin eingespart werden können, welche insbesondere auf der Leiterplatte bereits vorhanden sind. Insbesondere kann dadurch die Trägerplatte, welche als Leiterplatte ausgebildet ist, mittels einer Oberflächenmontagetechnologie hergestellt werden, sodass die Trägerplatte besonders schnell bauteil- und gewichtsreduziert hergestellt werden kann. Insgesamt ist dadurch die Bedienvorrichtung gewichtsreduziert und bauteilreduziert. Die Trägerplatte ist durch diese oben genannte Ausführung ein Multifunktionsbauteil.

Alternativ ist die Trägerplatte separat zu einer Leiterplatte. Auf der Leiterplatte können elektronische Komponenten der Bedienvorrichtung, wie beispielsweise eine Steuereinheit oder Kontaktierungselemente angeordnet sein. Die Trägerplatte und die Leiterplatte sind dann relativ zueinander bewegbar angeordnet.

Gemäß einer weiteren vorteilhaften Ausgestaltungsform kann das Federelement um das Koppelelement insbesondere vollständig umlaufend angeordnet sein. Insbesondere kann dadurch das Federelement platzsparend innerhalb der Bedienvorrichtung angeordnet werden. Des Weiteren kann dadurch eine homogene und möglichst lineare Bewegung des Bedienelements relativ zur Leiterplatte realisiert werden, sodass eine komfortable Betätigung des Bedienelements durch den Bediener durchgeführt werden kann. Sie kann ein anderes stiftartiges Element umlaufend umgreifen.

Ebenfalls vorteilhaft ist, wenn das Federelement eine Spiralfeder ist. Bei der Spiralfeder handelt es sich um ein einfaches Federelement, welche insbesondere zuverlässig, platzsparend und gewichtsreduziert innerhalb der Bedienvorrichtung angeordnet werden kann.

Es hat sich weiterhin als vorteilhaft erwiesen, wenn die zweite Elektrode, insbesondere vollständig, umlaufend um den Erdungskontakt ausgebildet ist. Insbesondere ist die zweite Elektrode beabstandet um den Erdungskontakt ausgebildet. Insbesondere sind die zweite Elektrode und der Erdungskontakt konzentrische Ringe. Dadurch ist es insbesondere ermöglicht, dass auf der Trägerplatte, welche insbesondere als Leiterplatte ausgebildet sein kann, raumsparend die zweite Elektrode und der Erdungskontakt ausgebildet sind. Dadurch ist auf der Trägerplatte mehr Platz für weitere Bauteile beziehungsweise elektrische Leitungen geschaffen, welche für die Bedienvorrichtung notwendig sind.

Gemäß einer weiteren vorteilhaften Ausgestaltungsform kann der Erdungskontakt von der zweiten Elektrode umgriffen sein. Dadurch ist es insbesondere möglich, dass die Messeinheit besonders bauraumsparend und dennoch mit einer hohen Auflösung betrieben werden kann.

Es hat sich weiterhin als vorteilhaft erwiesen, wenn das Koppelelement sich durch ein Loch in der Leiterplatte erstreckt und mit der ersten Elektrode fest verbunden ist und mit einem ersten Koppelelementende mit dem Bedienelement bewegungsgekoppelt ist. Insbesondere ist das Koppelelement stiftartig ausgebildet. Dadurch ist das Koppelelement materialsparend ausgebildet, sodass Gewicht eingespart werden kann. Des Weiteren ist ein Loch in der Leiterplatte ausreichend, um die Kraft bei Betätigung auf die erste Elektrode zu übertragen. Dadurch kann die Leiterplatte einfach hergestellt werden und die Leiterplatte bietet Bauraum für andere Einheiten, da lediglich ein Loch als Durchführung benötigt wird. Darüber hinaus sind sehr kurze Verbindungswege zwischen den Komponenten erreicht, wodurch ein kompakterer Aufbau begünstigt ist.

Insbesondere ist das Koppelelement mit einer Unterseite des Bedienelements mechanisch gekoppelt. Somit kann auch hier die Krafteinwirkung auf das Bedienelement direkt auf das Koppelelement weitergegeben werden, welches wiederum das Betätigen an die erste Elektrode überträgt, sodass abhängig von dem Wert der Abstandsänderung das Gerät einstellbar und/oder auswählbar ist.

Es hat sich weiterhin als vorteilhaft erwiesen, wenn zumindest eine der beiden Elektroden auf einer der anderen Elektrode zugewandten Oberseite eine Isolierschicht aufweist. Insbesondere kann dadurch verhindert werden, dass in der Nullstellung der Bedienvorrichtung beziehungsweise des Bedienelements die beiden Elektroden sich direkt berühren, und so einen elektrischen Kontakt aufbauen. Insbesondere kann dadurch bei einer Betätigung des Bedienelements eine spezifische Wertänderung erfasst werden. Ebenfalls möglich ist, dass, sollte beispielsweise die zweite Elektrode in der Leiterplatte integriert sein, die Isolierschicht durch das nichtleitende Material der Leiterplatte gebildet ist. Insbesondere kann dadurch mit wenig Montageaufwand und bauteilreduziert eine Isolation der beiden Elektroden, insbesondere in der Nullstellung, erreicht werden.

Ebenfalls vorteilhaft ist, wenn die zweite Elektrode in die Leiterplatte integriert ist. Durch die Integration der zweiten Elektrode in die Leiterplatte kann die Bedienvorrichtung bauraumsparend ausgebildet sein, da die zweite Elektrode keinen extra Bauraum innerhalb der Bedienvorrichtung benötigt. Insbesondere kann dadurch weiterhin vorgesehen sein, dass bereits bei Herstellung der Leiterplatte die zweite Elektrode mitintegriert ist, sodass beispielsweise mittels einer Oberflächenmontagetechnologie (Surface Mounted Technology - SMT) der Montageaufwand der Bedienvorrichtung verringert ist.

Bevorzugt kann die Leiterplatte eine Schirmelektrode aufweisen. Bei der Schirmelektrode kann es sich insbesondere um eine Guard-Elektrode handeln. Mittels dieser Ausgestaltungsform können auch kleine Veränderungen genau detektiert werden. Die zweite Elektrode ist dabei häufig mit der Schirmelektrode "umgeben", die den inhomogenen Randbereich des elektrischen Felds von der zweiten Elektrode abschirmt. Dadurch ergibt sich zwischen der zweiten und der ersten Elektrode ein annähernd paralleles elektrisches Feld mit der bekannten Charakteristik eines idealen Plattenkondensators. Insbesondere können störende elektromagnetische Felder von weiteren Bauteilen der Leiterplatte von der Messeinheit, insbesondere von der zweiten Elektrode, abgeschirmt werden. Mittels der Schirmelektrode können somit Messfehler verhindert werden, sodass auch diese Anordnung zur Erhöhung der elektrischen Empfindlichkeit beiträgt.

Ebenfalls vorteilhaft ist, wenn die erste Elektrode topfförmig, insbesondere hülsenförmig, ausgebildet ist und an einem ersten Ende der ersten Elektrode einen Elektrodenteller aufweist. Insbesondere kann dann vorgesehen sein, dass das Federelement innerhalb der topfförmigen ersten Elektrode angeordnet ist. Durch die Ausbildungsform, dass das erste Ende der ersten Elektrode einen Elektrodenteller aufweist, kann insbesondere der Elektrodenteller mit der zweiten Elektrode auf der Trägerplatte elektrisch wechselwirken, sodass insbesondere eine verbesserte Auflösung bei der Erfassung des physikalischen Parameters realisiert werden kann.

Erfindungsgemäß sind das Bedienelement und das Koppelelement separate Bauteile, die mechanisch verbunden sind. Außerdem weist die Bedienvorrichtung erfindungsgemäß eine Einstelleinrichtung auf, durch welche die Relativposition zwischen dem Bedienelement und dem Koppelelement veränderbar ist. Insbesondere ist die Relativposition nach dem Einstellen fixiert und nur im jeweils fixierten Zustand kann eine Betätigung erfolgen. Insbesondere kann dadurch die Bedienvorrichtung sehr individuell und situationsabhängig eingestellt werden. Erfindungsgemäß ist mittels der Einstelleinrichtung eine benötigte Kraft zum Bedienen der Bedienvorrichtung vorher einstellbar. Insbesondere kann dies erfolgen, da mittels der Einstelleinrichtung der Federweg des Federelements eingestellt werden kann. Über den Federweg des Federelements kann insbesondere die Kraft eingestellt werden, mit welcher die Bedienvorrichtung zu betätigen ist. Des Weiteren kann über die Einstelleinrichtung aufgrund des Federwegs die Auflösungsgenauigkeit der Bedienvorrichtung eingestellt werden. Somit ist die Bedienvorrichtung für viele Funktionen, insbesondere im Kraftfahrzeug, einsetzbar.

Gemäß einer weiteren vorteilhaften Ausgestaltungsform kann das Federelement an einer Unterseite eines Koppelelementkopfs anliegen. Dadurch kann insbesondere besonders zuverlässig die Erdung der ersten Elektrode durchgeführt werden, insbesondere da das Koppelelement, insbesondere der Koppelelementkopf mit der ersten Elektrode bewegungsgekoppelt ist, kann dadurch ein elektrischer Kontakt über den Koppelelementkopf hergestellt werden. Insbesondere durch die Einbringung des Federelements an der Unterseite ist somit das Federelement vor Umwelteinflüssen geschützt, sodass die Bedienvorrichtung zuverlässig und hochfunktionell betrieben werden kann.

Es hat sich weiterhin als vorteilhaft erwiesen, wenn das Federelement an einem Podest eines Verstellbereichs des Koppelelements anliegt. Insbesondere kann dann über den Verstellbereich das Federelement eingestellt werden. Insbesondere kann das Federelement in seiner Länge verändert werden, sodass dadurch zur Betätigung ein erhöhter oder reduzierter Kraftaufwand nach der Einstellung erforderlich ist. Insbesondere durch die Abstützung an dem Podest kann dann die entsprechend eingestellte Kraft von dem Federelement auf das Koppelelement übertragen werden, was wiederum die Kraft auf die erste Elektrode überträgt.

Gemäß einer weiteren vorteilhaften Ausgestaltungsform kann das Federelement über seine gesamte Erstreckung in Richtung einer Längsachse des Federelements betrachtet von der ersten Elektrode umgeben sein. Insbesondere kann dann das Federelement als elektrische Verbindung innerhalb der ersten Elektrode genutzt werden, sodass das Federelement vor Umwelteinflüssen geschützt ist und dadurch besonders zuverlässig betrieben werden kann.

Die Aspekt der Erfindung betrifft ein Kraftfahrzeug mit einer Bedienvorrichtung gemäß der Erfindung oder einer vorteilhaften Ausführungsform davon. Insbesondere kann das Kraftfahrzeug als Personenkraftfahrzeug ausgebildet sein.

Vorteilhafte Ausgestaltungsformen der Bedienvorrichtung sind als vorteilhafte Ausgestaltungsformen des erfindungsgemäßen Kraftfahrzeugs anzusehen.

Ausführungsbeispiele werden nachfolgend anhand von schematischen Zeichnungen erläutert.

Dabei zeigen:
- Fig. 1: ein Kraftfahrzeug gemäß einer Ausführungsform der Erfindung, welches eine Bedienvorrichtung aufweist;
- Fig. 2: eine schematische Querschnittansicht einer Ausführungsform einer Bedienvorrichtung;
- Fig. 3: eine weitere schematische Querschnittansicht einer Ausführungsform einer Bedienvorrichtung;
- Fig. 4: eine schematische Perspektivansicht einer Ausführungsform einer Bedienvorrichtung;
- Fig. 5: eine weitere schematische Perspektivansicht einer Ausführungsform einer Bedienvorrichtung;
- Fig. 6: eine weitere schematische Perspektivansicht einer Ausführungsform eines Bedienelements;
- Fig. 7: eine weitere schematische Querschnittansicht einer Ausführungsform einer Bedienvorrichtung;
- Fig. 8: eine weitere schematische Perspektivansicht einer Ausführungsform der Bedienvorrichtung;
- Fig. 9: eine weitere schematische Perspektivansicht einer Ausführungsform der Bedienvorrichtung;
- Fig. 10: eine weitere schematische Perspektivansicht einer Ausführungsform der Bedienvorrichtung;
- Fig. 11: eine weitere schematische Perspektivansicht einer Ausführungsform einer Bedienvorrichtung;
- Fig. 12: eine weitere schematische Querschnittsansicht einer Ausführungsform einer Bedienvorrichtung;
- Fig. 13: eine weitere schematische Querschnittsansicht einer Ausführungsform einer Bedienvorrichtung;
- Fig. 14: eine Detailansicht einer weiteren schematischen Querschnittsansicht einer Ausführungsform der Bedienvorrichtung gemäß Fig. 12; und
- Fig. 15: eine Detailansicht einer weiteren schematischen Querschnittansicht einer Ausführungsform der Bedienvorrichtung gemäß Fig. 13.

In den Figuren sind gleiche oder funktionsgleiche Elemente mit den gleichen Bezugszeichen versehen.

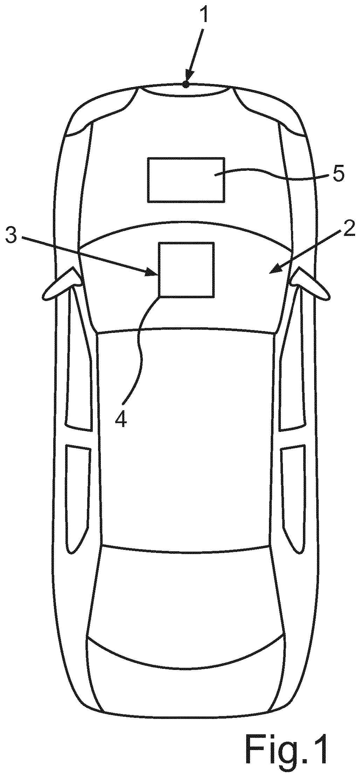

Fig. 1 zeigt ein Kraftahrzeug 1 gemäß einer Ausführungsform der Erfindung in einer Draufsicht. Das Kraftfahrzeug 1 ist vorliegend als Personenkraftwagen ausgebildet. Das Kraftfahrzeug 1 umfasst einen Innenraum 2, in welchem eine Bedienvorrichtung 3 angeordnet ist. Die Bedienvorrichtung 3, welche vorliegend schematisch dargestellt ist, umfasst zumindest ein Bedienelement 4, welches von einem Insassen des Kraftfahrzeugs 1 bedient werden kann. Die Bedienvorrichtung 3 kann derart im Innenraum 2 des Kraftfahrzeugs 1 angeordnet sein, dass das Bedienelement 4 dem Insassen des Kraftfahrzeugs 1 zugewandt ist.

Mit der Bedienvorrichtung 3 kann eine Bedienhandlung in Form der Betätigung des Bedienelements 4 erfasst werden. Durch eine Kraftaufbringung auf das Bedienelement 4 durch einen Nutzer beziehungsweise durch einen Bediener, beispielsweise einem Fahrer des Kraftfahrzeugs 1, kann ein entsprechendes Steuersignal ausgegeben werden.

Insbesondere kann vorgesehen sein, dass mittels der Bedienvorrichtung 3 zumindest ein Gerät 5 des Kraftfahrzeugs 1 bedient werden kann. Es kann auch vorgesehen sein, dass mit der Bedienvorrichtung 3 mehrere Funktionen des Geräts 5 bedient werden können beziehungsweise mehrere Geräte 5 mit der Bedienvorrichtung 3 bedient werden können.

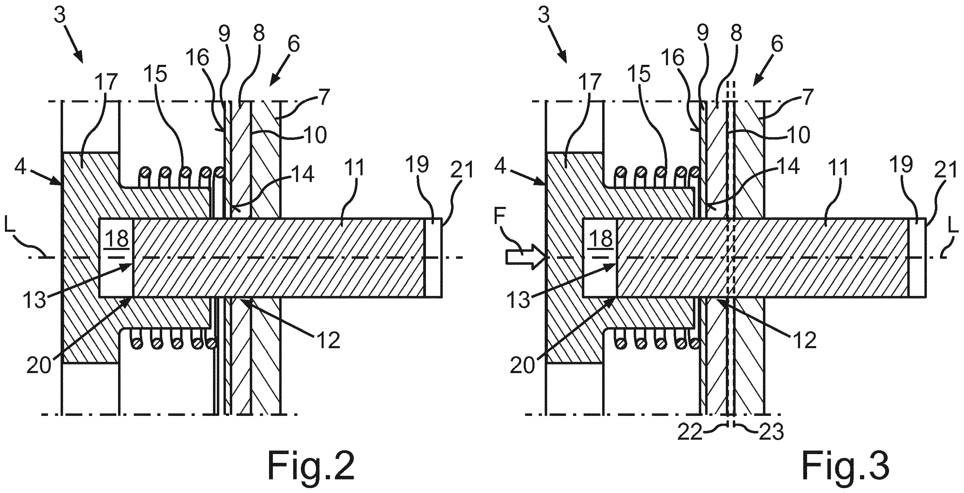

Fig. 2 zeigt eine schematische Querschnittansicht einer Ausführungsform einer Bedienvorrichtung 3. Die Bedienvorrichtung 3 weist insbesondere eine elektronische Messeinheit 6 auf. Die Messeinheit 6 weist eine erste Elektrode 7 sowie eine zweite Elektrode 8 auf. Die erste Elektrode 7 sowie die zweite Elektrode 8 können insbesondere ringförmig und/oder zylinderförmig ausgebildet sein. Es ist ebenfalls möglich, dass die erste Elektrode 7 oder die zweite Elektrode 8 rechteckförmig ausgebildet sind. Insbesondere ist vorgesehen, dass die zweite Elektrode 8 auf einer Leiterplatte 9 der Bedienvorrichtung 3 ausgebildet ist. Insbesondere ist die zweite Elektrode 8 in der Leiterplatte 9 integriert. Insbesondere ist vorgesehen, dass zumindest eine der beiden Elektroden 7, 8 auf einer der anderen Elektrode 7, 8 zugewandten Oberseite eine Isolierschicht 10 aufweist. Mittels der Isolierschicht 10 sind die beiden Elektroden 7, 8 elektrisch voneinander getrennt. Die Elektroden 7, 8 liegen dann nur durch die Isolierschicht 10 voneinander elektrisch getrennt direkt aufeinander auf. Insbesondere ist die zweite Elektrode 8 ortsfest auf der Leiterplatte 9 angeordnet. Die zweite Elektrode 8 ist insbesondere auf einer ersten Seite 14 der Leiterplatte 9 angeordnet und insbesondere dem Bedienelement 4 damit abgewandt auf der Leiterplatte 9 angeordnet.

Insbesondere sind die erste Elektrode 7 und die zweite Elektrode 8 parallel zur Leiterplatte 9 orientiert, wobei insbesondere die erste Elektrode 7 in Richtung senkrecht zu der ersten Seite 14 zur zweiten Elektrode 8 bewegbar ist. Insbesondere sind somit die beiden Elektroden 7, 8 zueinander parallel orientiert.

Ferner weist die Bedienvorrichtung 3 ein insbesondere stabförmiges beziehungsweise stiftartiges Koppelelement 11 auf, welches sich insbesondere durch ein Loch 12 in der Leiterplatte 9 erstreckt und mit der ersten Elektrode 7 verbunden ist. Insbesondere ist das Koppelelement 11 mit der zweiten Elektrode 7 bewegungsgekoppelt. Insbesondere ist das Koppelelement 11 mit einem ersten Koppelelementende 13 mit dem Bedienelement 4 ebenfalls bewegungsgekoppelt.

Insbesondere sind somit die erste Elektrode 7 und das Bedienelement 4 über das Koppelelement 11 miteinander mechanisch gekoppelt. Insbesondere kann vorgesehen sein, dass das Koppelelement 11 als ein Koppelstift ausgebildet ist.

Insbesondere ist vorgesehen, dass das Bedienelement 4 und das Koppelelement 11 separate Bauteile sind, die mechanisch miteinander verbunden sind. Insbesondere Mittels einer Einstelleinrichtung 19 der Bedienvorrichtung 3 kann eine Relativposition zwischen dem Bedienelement 3 und dem Koppelelement 11 veränderbar sein. Insbesondere wird das Koppelelement 11 nach dem Einstellen der jeweiligen Relativposition fixiert, sodass eine Betätigung im jeweils nur fixierten Zustand erfolgt.

Ferner weist die Bedienvorrichtung 3 eine Rückstelleinrichtung 15 auf. Insbesondere ist vorgesehen, dass die Rückstelleinrichtung 15 an einer dem Bedienelement 4 zugewandten Seite 16 der Leiterplatte 9 abgestützt ist. Insbesondere ist weiter vorgesehen, dass die Rückstelleinrichtung 15 an einem topfförmigen Träger 17 des Bedienelements 4 angeordnet ist, wobei der Träger 17 mit dem Bedienelement 4 bewegungsgekoppelt ist.

Insbesondere ist vorgesehen, dass das Bedienelement 4 bereichsweise topfförmig ausgebildet ist und das dazu separate Koppelelement 11 in einem topfförmigen Bereich 18 des Bedienelements 4 eintauchend angeordnet ist. Insbesondere sind unterschiedliche Relativpositionen des Koppelelements zu dem Bedienelement 4 im eingetauchten Zustand durch die Einstelleinrichtung 19 positionsfixierbar. Insbesondere kann zwischen dem Bedienelement 4 und dem Koppelelement 11 eine Koppelstruktur 20 ausgebildet sein, welche insbesondere als Gewinde ausgebildet ist. Somit kann im Zusammenspiel mit der Einstelleinrichtung 19 und der Koppelstruktur 20 die Relativposition des Koppelelements 11 und der Bedienvorrichtung 4 verstellt, insbesondere fein und kontinuierlich verstellt, werden, und damit insbesondere auch eine Relativposition des Bedienelements 4 zur Leiterplatte 9 eingestellt werden. Insbesondere kann dann an einem dem Bedienelement 4 abgewandten Ende 21 des Koppelelements 11 ein zum Eingriff mit einem Werkzeug ausgebildeter Verstellbereich, mit anderen Worten die Einstelleinrichtung 19, zum Verstellen einer Relativposition zwischen dem Bedienelement 4 und dem Koppelelement 11 angeordnet sein.

Des Weiteren ist insbesondere vorgesehen, dass die Rückstelleinrichtung 15 um das Koppelelement 11 umlaufend angeordnet ist.

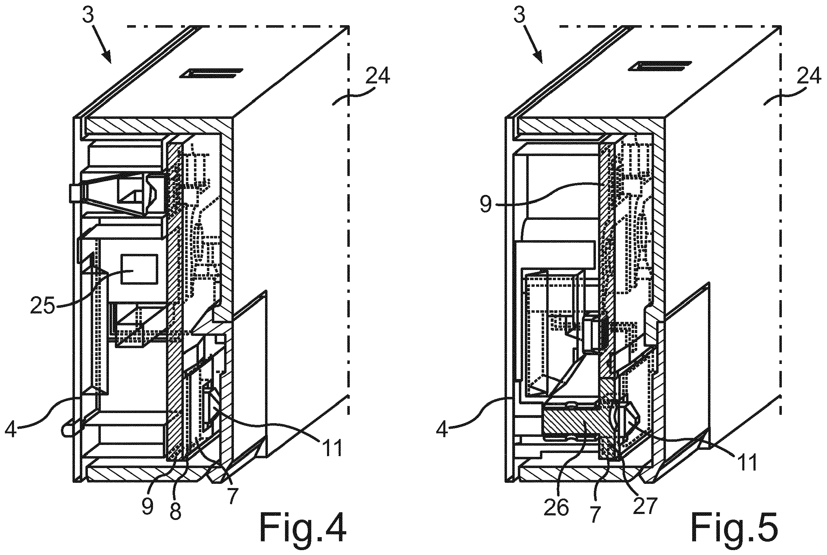

Fig. 3 zeigt eine weitere schematische Querschnittansicht einer Ausführungsform der Bedienvorrichtung 3. Die Bedienvorrichtung 3 befindet sich insbesondere in einem betätigten Zustand. Dies bedeutet, dass insbesondere ein Bediener der Bedienvorrichtung 3 das Bedienelement 4 betätigt hat, indem er eine Kraft F auf das Bedienelement 4 ausgeübt hat. Dadurch, dass das Bedienelement 4 mit dem Koppelelement 11 bewegungsgekoppelt ist, wurde dabei auch das Koppelelement 11 relativ zur Leiterplatte 9 bewegt. Die erste Elektrode 7 ist ebenfalls mit dem Koppelelement 11 bewegungsgekoppelt, sodass sich die erste Elektrode 7 ebenfalls relativ zur Leiterplatte 9 bewegt hat. Insbesondere ist die erste Elektrode 7 aus einer Nullstellung 22, die in Fig. 2 gezeigt ist in eine ausgelenkte Stellung 23 gerückt. Zwischen der ersten Elektrode 7 und der zweiten Elektrode 8 ist insbesondere ein Abstand entstanden. Mittels diesem Abstand A ist nun ein Wert eines physikalischen Parameters durch die Messeinheit 6, insbesondere durch eine Auswerteeinheit 25 (Fig. 4) der Messeinheit 6, erfassbar. Abhängig von dem Wert kann dann das Gerät 5 bedient werden. Insbesondere kann vorgesehen sein, dass abhängig von unterschiedlichen Werten bei unterschiedlichen Abständen A auch unterschiedliche Geräte 5 beziehungsweise unterschiedliche Betriebsarten des Geräts 5 bedienbar sind.

Ein physikalischer Parameter kann insbesondere ein Kapazitätswert oder ein Induktivitätswert sein, welche insbesondere auch eine Kapazitätsänderung oder eine Induktivitätsänderung sein können, welche durch den Abstand A der beiden Elektroden 7, 8 zueinander entstehen.

Insbesondere ist nun vorgesehen, dass, sollte der Bediener nicht mehr die Kraft F auf das Bedienelement 4 ausüben, sich mittels der Rückstelleinrichtung 15, welche insbesondere als Spiralfeder ausgebildet ist, die erste Elektrode 7 selbstständig in die Nullstellung 22 zurückbewegt. Mit anderen Worten wird nach Beendigung der Betätigung die erste Elektrode 7 wieder in die Nullstellung 22 automatisch zurückgebracht. Dadurch kann mit einer erhöhten Auflösung, da immer von der festen Nullstellung 22 ausgegangen werden kann, die Bedienvorrichtung 3 vorteilhafter bedient werden.

Fig. 4 zeigt eine schematische Perspektivansicht einer Ausführungsform einer Bedienvorrichtung 3. In dem folgenden Ausführungsbeispiel weist die Bedienvorrichtung 3 ein Gehäuse 24 auf. In dem Gehäuse 24 ist die Leiterplatte 9 mit der daraufliegenden beziehungsweise integrierten zweiten Elektrode 8 angeordnet. In Fig. 4 befindet sich die Bedienvorrichtung 3 in der Nullstellung 22, sodass die erste Elektrode 7 auf der zweiten Elektrode 8 direkt aufliegt. Insbesondere sind die beiden Elektroden 7, 8 mittels der Isolierschicht 10 voneinander isoliert. Insbesondere weist die Leiterplatte 9 das Loch 12 auf, sodass das Koppelelement 11 durch die Leiterplatte 9 hindurchgesteckt ist. Insbesondere ist das Koppelelement 11 mit der ersten Elektrode 7 bewegungsgekoppelt. Insbesondere kann dann bei einem Betätigen des Bedienelements 4, mit anderen Worten ein Drücken auf das Bedienelement 4, die erste Elektrode 7 mittels des bewegungsgekoppelten Koppelelements 11 von der zweiten Elektrode 8 wegbewegt werden. Mittels der Auswerteeinheit 25 kann dann der Wert der physikalischen Größe bestimmt werden, auf dessen Basis dann das Gerät 5 bedient wird. Im vorliegenden Beispiel sind die beiden Elektroden 7, 8 als flache rechteckige Platten ausgebildet.

Fig. 5 zeigt eine weitere Perspektivansicht einer Ausführungsform einer Bedienvorrichtung 3. In dem in Fig. 5 gezeigten Beispiel ist die erste Elektrode 7 zweiteilig ausgebildet. Ein erster Teil 26 ist insbesondere mit dem Bedienelement 4 bewegungsgekoppelt und kann insbesondere zur Erdung der ersten Elektrode 7 dienen. Des Weiteren dient der erste Teil 26 als Bewegungsführung der ersten Elektrode 7 mit dem Bedienelement 4. Der zweite Teil 27 der ersten Elektrode 7 dient insbesondere weiterhin zur Wechselwirkung mit der zweiten Elektrode 8 auf der Leiterplatte 9. Insbesondere ist mittels dieser Ausgestaltungsform eine sichere und homogene Bewegung bei Betätigung möglich, da ein Verkippen der ersten Elektrode 7 relativ zur zweiten Elektrode 8 aufgrund der Führung des ersten Teils 26 der ersten Elektrode 7 verhindert ist. Dadurch kann eine sichere Bedienung der Bedienvorrichtung 3 realisiert werden.

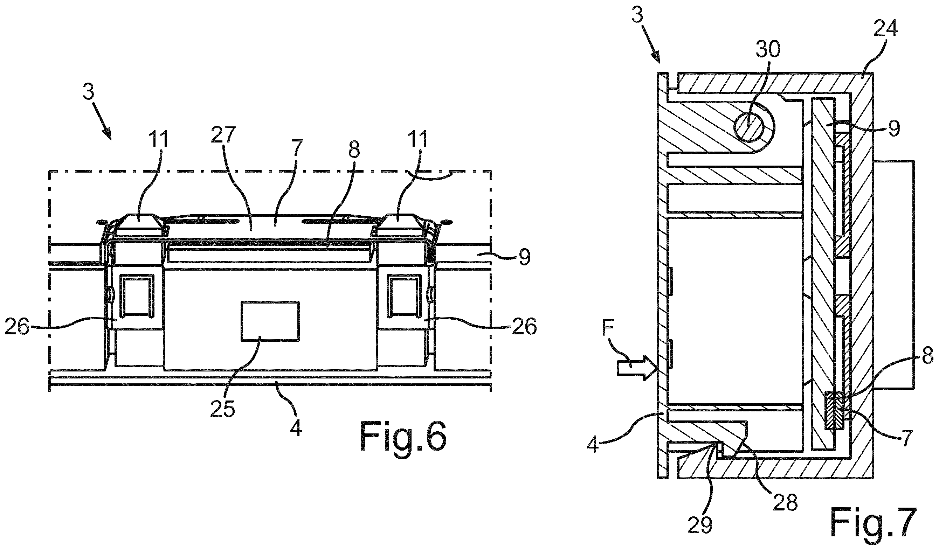

Fig. 6 zeigt eine weitere Perspektivansicht einer Ausführungsform der Bedienvorrichtung 3. Insbesondere zeigt Fig. 6 in vergrößerter Form die erste Elektrode 7, wie sie bereits aus Fig. 5 bekannt ist. Insbesondere weist die erste Elektrode 7 den ersten Teil 26 und den zweiten Teil 27 auf. Der zweite Teil 27 ist zum Wechselwirken mit der zweiten Elektrode 8 ausgebildet. Mittels des ersten Teils 26 kann insbesondere eine sichere Bewegungskopplung mit dem Koppelelement 11 und eine sichere Führung realisiert werden. Des Weiteren kann über den ersten Teil 26 beispielsweise auch ein Massepotential der ersten Elektrode 7 erreicht werden. Insbesondere kann mittels der Ausgestaltungsform aus Fig. 6 eine sichere und insbesondere parallele Verschiebung der ersten Elektrode 7 zur zweiten Elektrode 8 realisiert werden, sodass besonders zuverlässig der Wert der physikalischen Größe über die Auswerteeinheit 25 bestimmt werden kann und abhängig davon das Gerät 5 bedient werden kann.

Fig. 7 zeigt eine weitere Querschnittansicht einer Ausführungsform einer Bedienvorrichtung 3. In der vorliegenden Ausführungsform schwenkt das Bedienelement 4 bei der Betätigung mit der Kraft F um eine Drehachse 30 der Bedienvorrichtung 3. Beim Schwenken um die Drehachse 30 bewegt sich insbesondere die erste Elektrode 7 insbesondere nahezu linear von der zweiten Elektrode 8 weg, wodurch der Wert der physikalischen Größe erfasst werden kann. Insbesondere kann bei dieser Ausgestaltungsform vorgesehen sein, dass die Bedienvorrichtung 3 eine bedienelementexterne Rastnase 29 und das Bedienelement 4 einen Rasthaken 28 aufweist. Der Rasthaken 28 und die Rastnase 29 können insbesondere in der Nullstellung aneinander anschlagen, sodass eine Bewegung entgegen der Kraft F durch die Rastnase 29 und den Rasthaken 28 begrenzt ist. Diese Elemente stellen daher Bewegungsbegrenzungsanschläge dar. Somit kann insgesamt neben einem rein linear betätigbaren Bedienelement 4, wie in den Fig. 2 - 6 gezeigt, durch die Ausführungsform aus Fig. 7 auch ein Wipptastendrehprinzip durchgeführt werden. Somit ist der erfindungsgemäße Gedanke funktionell in einer weiteren Ausgestaltungsform umsetzbar.

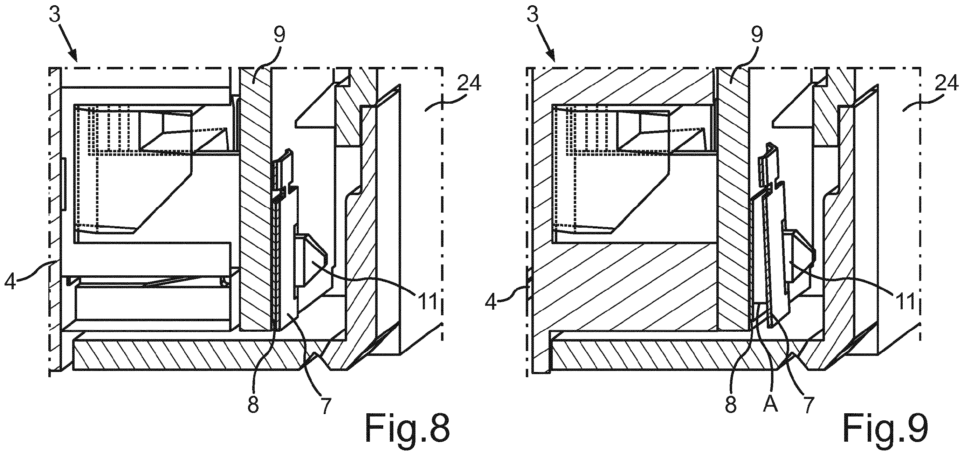

Fig. 8 zeigt die Bedienvorrichtung aus Fig. 7 in der Nullstellung 22. Die erste Elektrode 7 liegt auf der zweiten Elektrode 8 auf. Die erste Elektrode 7 und die zweite Elektrode 8 sind insbesondere als rechteckförmige Platten ausgebildet. Die erste Elektrode 7 ist mit dem Koppelelement 11 bewegungsgekoppelt.

Fig. 9 zeigt die Bedienvorrichtung 3 aus Fig. 7 beziehungsweise aus Fig. 8 in einer betätigten Position, also in der ausgelenkten Stellung 23. Insbesondere ist zwischen der ersten Elektrode 7 und der zweiten Elektrode 8 der Abstand A aufgetreten. Insbesondere zeigt Fig. 9, dass auch bei einer Schwenkbewegung eine nahezu lineare Abstandänderung zwischen den beiden Elektroden 7, 8 auftritt. Insbesondere kann dadurch auch bei dem Schwenken um die Drehachse 30 eine sehr hohe Auflösung bei dem Abstand A erfasst werden, sodass das Gerät 5 fein aufgelöst bedient werden kann.

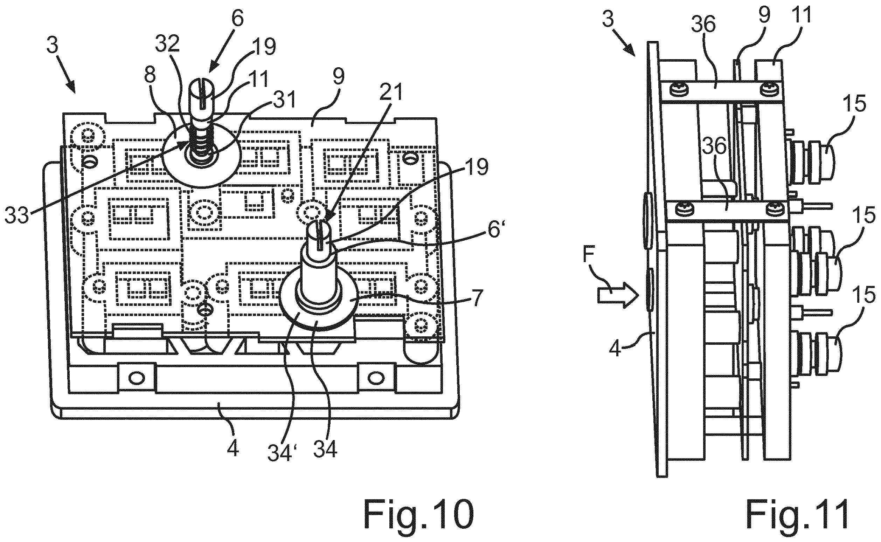

Fig. 10 zeigt eine weitere Perspektivansicht einer Ausführungsform der Bedienvorrichtung 3. Fig. 10 zeigt insbesondere, dass auf der Leiterplatte 9, welche hier auch als eine Trägerplatte 9 (Fig. 11) ausgebildet ist und somit ein gleiches Bauteil sind, ein Erdungskontakt 31 ausgebildet ist, welcher auch als Massekontakt bezeichnet werden kann. Der Erdungskontakt 31 ist mit einer Erdungsverbindung 32 verbunden. Insbesondere kann vorgesehen sein, dass die Erdungsverbindung 32 ein zum Erdungskontakt 31 separates Federelement 33 aufweist, welches das Koppelelement 11 umgreift und bei dem durch die Relativbewegungen zwischen den Elektroden 7, 8 auftretenden unterschiedlichen Abständen A jeweils sowohl mit dem Erdungskontakt 31 als auch mit der ersten Elektrode 7 kontaktiert. Insbesondere zeigt Fig. 10 die Messeinheit 6 und eine separate zweite Messeinheit 6'. Bei der Messeinheit 6 ist die erste Elektrode 7 nicht dargestellt, während bei der zweiten Messeinheit 6' die erste Elektrode 7 dargestellt ist, jedoch deshalb sowohl die zweite Elektrode 8 als auch der Erdungskontakt 31, die Erdungsverbindung 32 und das Federelement 33 nicht dargestellt sind.

Bei der Messeinheit 6 ist ersichtlich, dass die zweite Elektrode 8 ringartig umlaufend um den Erdungskontakt 31 und radial dazu beabstandet ausgebildet ist. Insbesondere ist die zweite Elektrode 8 beabstandet zum Erdungskontakt 31 und insbesondere sind die zweite Elektrode 8 und der Erdungskontakt 31 als konzentrische Ringe ausgebildet. Insbesondere ist dabei der Erdungskontakt 31 von der zweiten Elektrode 8 umgriffen.

Bei der zweiten Messeinheit 6' ist insbesondere ersichtlich, dass die erste Elektrode 7 topfförmig, insbesondere hülsenförmig, ausgebildet ist und an einem ersten Ende 34 eines rohrartigen Teils der ersten Elektrode 7 einen Elektrodenteller 34' aufweist.

Des Weiteren zeigt Fig. 10 insbesondere die Einstelleinrichtung 19 mit dem Verstellbereich am ersten Ende 21, welcher insbesondere mit einem Schlitzschraubenzieher als Werkzeug beispielsweise verstellt werden kann, sodass das Bedienelement 3 in seiner Relativposition verändert werden kann.

Fig. 11 zeigt eine weitere Perspektivansicht einer Ausführungsform einer Bedienvorrichtung 3. Insbesondere sind als Rückstelleinrichtung 15 elastisch verformbare Massivkörper ausgebildet. Insbesondere können diese verformbaren Massivkörper aus Silikon beziehungsweise Elastomer ausgebildet sein. Insbesondere zeigt Fig. 11, dass ein zur Leiterplatte 9 separates Koppelelement 11 ausgebildet ist, welches vorliegend plattenartig ausgebildet und über Verbindungen 36 mit dem Bedienelement 4 bewegungsgekoppelt ist. Das Koppelelement 11 liegt vorliegend direkt auf den Massivblöcken auf ausgebildet ist. Insbesondere sind die Massivblöcke der Rückstelleinrichtung 15 mit dem Koppelelement verbunden. Bei einer Kraftbeaufschlagung mit der Kraft F des Bedienelements 4 werden die Massivblöcke verformt und dadurch kann nach einer Betätigung der Bedienvorrichtung 3 das Bedienelement 4 wieder in die Nullstellung 22 gebracht werden. Insbesondere bewegt sich 'das Koppelelement 11 bei der Betätigung des Bedienelements 4 mit dem Bedienelement 4. Die Leiterplatte 9 bleibt in der Ausgangsstellung zurück, sodass die erste Elektroden 7 gegenüber der Leiterplatte 9 und damit gegenüber der zweiten Elektrode 8 mitbewegt wird.

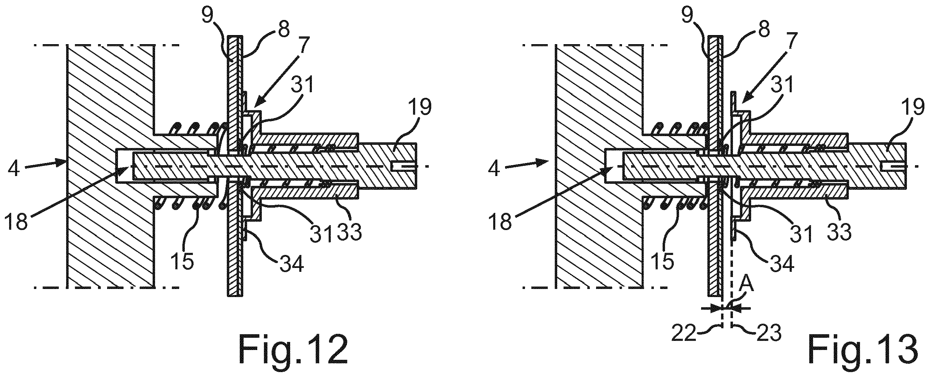

Fig. 12 zeigt eine schematische Querschnittansicht einer Ausführungsform der Bedienvorrichtung 3. Die Bedienvorrichtung 3 befindet sich vorliegend in der Nullstellung 22. Die beiden Elektroden 7, 8 liegen sind insbesondere parallel zueinander ausgerichtet. Mittels der Rückstelleinrichtung 15 werden die Elektroden 7,8 aneinander gedrückt. Die erste Elektrode 7 ist mittels des Federelements 33 und der Erdungsverbindung 32 mit dem Erdungskontakt 31 elektrisch gekoppelt. Der Erdungskontakt 31 ist insbesondere von der zweiten Elektrode 8 isoliert.

Fig. 13 zeigt eine schematische Querschnittansicht einer Ausführungsform der Bedienvorrichtung 3 gemäß Fig. 12. Vorliegend befindet sich die Bedienvorrichtung 3 in der ausgelenkten Stellung 23 und die beiden Elektroden 7, 8 weisen einen Abstand A zueinander auf. Mittels des Federelements 33 kann auch in der ausgelenkten Stellung 23 die erste Elektrode 7 mit dem Erdungskontakt 31 geerdet werden da das Federelement 33 längenveränderlich ist und somit auch bei den unterschiedlichen Relativpositionen der beiden Elektroden 7, 8 die elektrische Kopplung aufrecht erhält, so dass der physikalische Parameter erfassbar ist.

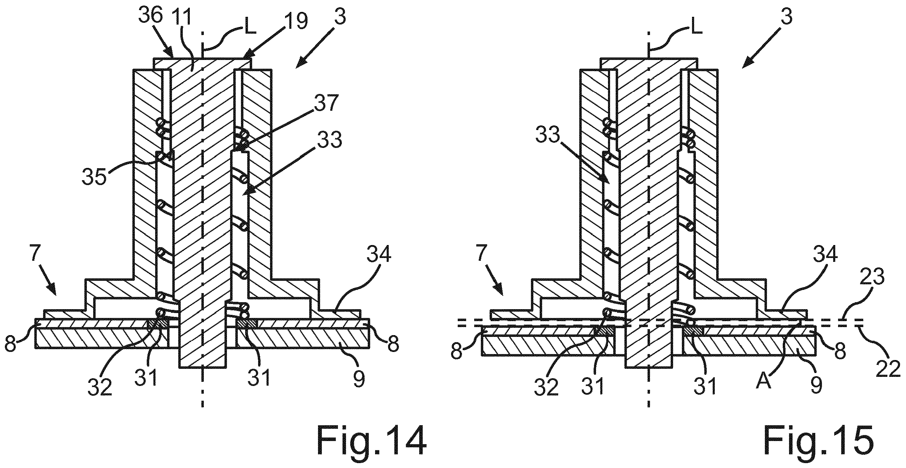

Fig. 14 zeigt eine Detailansicht einer weiteren schematischen Querschnittansicht einer Ausführungsform der Bedienvorrichtung 3 gemäß Fig. 12. Insbesondere zeigt Fig. 12 die Bedienvorrichtung 3 in der Nullstellung 22. Mit anderen Worten liegt die erste Elektrode 7 auf der zweiten Elektrode 8 auf. Insbesondere liegt die erste Elektrode 7 mit dem Elektrodenteller 34' auf der zweiten Elektrode 8 auf. Die erste Elektrode 7 ist wiederum über das Federelement 33 und der Erdungsverbindung 32 mit dem Erdungskontakt 31 elektrisch gekoppelt und damit geerdet. Insbesondere ist vorgesehen, dass zwischen der ersten Elektrode 7 und der zweiten Elektrode 8 die Isolierschicht 10 ausgebildet ist. Des Weiteren ist insbesondere vorgesehen, dass die zweite Elektrode 8 und der Erdungskontakt 31 elektrisch voneinander getrennt sind. Insbesondere ist vorgesehen, dass das Federelement 33 an einer Unterseite 35 des Koppelelementkopfs 36 abgestützt ist. Insbesondere kann das Federelement 33 an einem Podest 37 des Verstellbereichs des Koppelelements 11 anliegen. Insbesondere ist ebenfalls vorgesehen, dass das Federelement 33 über seine gesamte Erstreckung in Richtung einer Längsachse L des Federelements 33 betrachtet von der ersten Elektrode 7 umgeben ist.

Fig. 15 zeigt ferner eine weitere Detailansicht einer Ausführungsform der Bedienvorrichtung 3 aus Fig. 13 in der ausgelenkten Stellung 23. Die erste Elektrode 7 weist zur zweiten Elektrode 8 einen Abstand A auf, welcher aufgrund der Abstandsänderung durch Betätigen des Bedienelements 4 eingetreten ist. Durch die Ausgestaltungsform der Erdungsverbindung 32 als Federelement 33 kann auch in der ausgelenkten Stellung 23 die Erdung mit dem Erdungskontakt 31 realisiert werden, da sich insbesondere das Federelement 33 in seiner Länge verändern kann. Dadurch kann der Wert für den physikalischen Parameter bestimmt werden, wodurch das Gerät 5 bedient werden kann.

## Patentansprüche

1. Bedienvorrichtung (3) zum Bedienen von zumindest einem Gerät (5) eines Kraftfahrzeugs (1), mit einem Bedienelement (3) und mit einer Messeinheit (6, 6'), die eine erste Elektrode (7) und ein zweite Elektrode (8) aufweist, welche abhängig von einer Betätigung des Bedienelements (3) relativ zueinander bewegbar sind, und abhängig von einem Abstand (A) der ersten Elektrode (7) und der zweiten Elektrode (8) zueinander ein Wert eines physikalischen Parameters durch die Messeinheit (6, 6') erfassbar ist und in Abhängigkeit des Werts das Gerät (5) bedienbar ist,
wobei die Bedienvorrichtung (3) ein Koppelelement (11) aufweist, welches mit dem Bedienelement (4) und mit der ersten Elektrode (7) bewegungsgekoppelt ist, und die Bedienvorrichtung (3) eine Trägerplatte (9) aufweist, auf welcher die zweite Elektrode (8) ausgebildet ist, und ein Erdungskontakt (31) einer Erdungsverbindung (32) zum Erden der ersten Elektrode (7) auf der Trägerplatte (9) ausgebildet ist,
wobei die Erdungsverbindung (32) ein zum Erdungskontakt (31) separates Federelement (33) aufweist, welches bei den durch die Relativbewegungen zwischen den Elektroden (7, 8) auftretenden unterschiedlichen Abständen (A) jeweils sowohl mit dem Erdungskontakt (31) und der ersten Elektrode (7) kontaktiert ist, **dadurch gekennzeichnet, dass**
das Bedienelement (4) und das Koppelelement (11) separate Bauteile sind, die mechanisch verbunden sind und die Bedienvorrichtung (3) eine Einstelleinrichtung (19) aufweist, durch welche die Relativposition zwischen dem Bedienelement (4) und dem Koppelelement (11) veränderbar ist, so dass die zur Bedienung der Bedienvorrichtung benötigte Kraft einstellbar ist.

2. Bedienvorrichtung (3) nach Anspruch 1,
**dadurch gekennzeichnet, dass**
die Trägerplatte als eine Leiterplatte (9) der Bedienvorrichtung (3) ausgebildet ist.

3. Bedienvorrichtung (3) nach einem der vorhergehenden Ansprüche,
**dadurch gekennzeichnet, dass**
das Federelement (33) umlaufend um das Koppelelement (11) angeordnet ist.

4. Bedienvorrichtung (3) nach einem der vorhergehenden Ansprüche,
**dadurch gekennzeichnet, dass**
das Federelement (33) als Spiralfeder ausgebildet ist.

5. Bedienvorrichtung (3) nach einem der vorhergehenden Ansprüche,
**dadurch gekennzeichnet, dass**
die zweite Elektrode (7) umlaufend um den Erdungskontakt (31) ausgebildet ist.

6. Bedienvorrichtung (3) nach Anspruch 4,
**dadurch gekennzeichnet, dass**
der Erdungskontakt (31) von der zweiten Elektrode (8) umgriffen ist.

7. Bedienvorrichtung (3) nach einem der vorhergehenden Ansprüche,
**dadurch gekennzeichnet, dass**
das Koppelelement (11) sich durch ein Loch (12) in der Trägerplatte (9) erstreckt und mit der ersten Elektrode (7) fest verbunden ist und mit einem ersten Koppelelementende (13) mit dem Bedienelement (4) mechanisch gekoppelt ist.

8. Bedienvorrichtung (3) nach einem der vorhergehenden Ansprüche,
**dadurch gekennzeichnet, dass**
zumindest eine der beiden Elektroden (7, 8) auf einer der anderen Elektrode (7, 8) zugewandten Oberseite eine Isolierschicht (10) aufweist.

9. Bedienvorrichtung (3) nach einem der vorhergehenden Ansprüche,
**dadurch gekennzeichnet, dass**
die zweite Elektrode (8) in die Trägerplatte (9) integriert ist.

10. Bedienvorrichtung (3) nach einem der vorhergehenden Ansprüche,
**dadurch gekennzeichnet, dass**
die erste Elektrode (7) topfförmig ausgebildet ist und an einem ersten Ende (21) der ersten Elektrode (7) einen Elektrodenteller (34') aufweist.

11. Bedienvorrichtung (3) nach einem der vorhergehenden Ansprüche,
**dadurch gekennzeichnet, dass**
das Federelement (33) an einer Unterseite (35) eines Koppelelementkopfs (36) anliegt.

12. Bedienvorrichtung (33) nach einem der vorhergehenden Ansprüche,
**dadurch gekennzeichnet, dass**
das Federelement (33) an einem Podest (37) eines Verstellbereichs des Koppelements (11) anliegt.

13. Bedienvorrichtung (3) nach einem der vorhergehenden Ansprüche,
**dadurch gekennzeichnet, dass**
das Federelement (33) über seine gesamte Erstreckung in Richtung einer Längsachse (L) des Federelements (33) betrachtet von der ersten Elektrode (7) umgeben ist.

14. Kraftfahrzeug (1) mit einer Bedienvorrichtung (3) nach einem der Ansprüche 1 bis 13.

## Claims

1. Operating device (3) for operating at least one item of equipment (5) of a motor vehicle (1), with an operating element (3) and with a measuring unit (6, 6'), which has a first electrode (7) and a second electrode (8), which, dependent on an actuation of the operating element (3), are movable in relation to one another and, dependent on a distance (A) between the first electrode (7) and the second electrode (8), a value of a physical parameter can be sensed by the measuring unit (6, 6') and the item of equipment (5) can be operated in dependence on the value,
wherein the operating device (3) has a coupling element (11), which is coupled in terms of movement with the operating element (4) and with the first electrode (7), and the operating device (3) has a carrier plate (9), on which the second electrode (8) is formed, and an earthing contact (31) of an earthing connection (32) for earthing the first electrode (7) is formed on the carrier plate (9),
wherein the earthing connection (32) has a spring element (33), which is separate from the earthing contact (31) and, with the different distances (A) occurring between the electrodes (7, 8) due to the relative movements, is in each case in contact with the earthing contact (31) and the first electrode (7), **characterized in that**
the operating element (4) and the coupling element (11) are separate components, which are mechanically connected, and the operating device (3) has a setting means (19), by which the relative position between the operating element (4) and the coupling element (11) can be changed, so that the force required for operating the operating device can be set.

2. Operating device (3) according to Claim 1,
**characterized in that**
the carrier plate is formed as a printed circuit board (9) of the operating device (3).

3. Operating device (3) according to either of the preceding claims,
**characterized in that**
the spring element (33) is arranged running around the coupling element (11).

4. Operating device (3) according to one of the preceding claims,
**characterized in that**
the spring element (33) is formed as a spiral spring.

5. Operating device (3) according to one of the preceding claims,
**characterized in that**
the second electrode (7) is formed running around the earthing contact (31).

6. Operating device (3) according to Claim 4,
**characterized in that**
the earthing contact (31) is gripped around by the second electrode (8).

7. Operating device (3) according to one of the preceding claims,
**characterized in that**
the coupling element (11) extends through a hole (12) in the carrier plate (9) and is securely connected to the first electrode (7) and mechanically coupled by a first coupling element end (13) with the operating element (4) .

8. Operating device (3) according to one of the preceding claims,
**characterized in that**
at least one of the two electrodes (7, 8) has an insulating layer (10) on an upper side facing the other electrode (7, 8).

9. Operating device (3) according to one of the preceding claims,
**characterized in that**
the second electrode (8) is integrated in the carrier plate (9).

10. Operating device (3) according to one of the preceding claims,
**characterized in that**
the first electrode (7) is formed in the shape of a pot and has an electrode cup (34') at a first end (21) of the first electrode (7).

11. Operating device (3) according to one of the preceding claims,
**characterized in that**
the spring element (33) lies against an underside (35) of a coupling element head (36).

12. Operating device (3) according to one of the preceding claims,
**characterized in that**
the spring element (33) lies against a pedestal (37) of an adjusting region of the coupling element (11).

13. Operating device (3) according to one of the preceding claims,
**characterized in that**
the spring element (33) is surrounded by the first electrode (7) over its entire extent, as seen in the direction of the longitudinal axis (L) of the spring element (33).

14. Motor vehicle (1) with an operating device (3) according to one of Claims 1 to 13.

## Revendications

1. Arrangement de commande (3) destiné à commander au moins un appareil (5) d'un véhicule automobile (1), comprenant un élément de commande (3) et comprenant une unité de mesure (6, 6'), laquelle possède une première électrode (7) et une deuxième électrode (8), lesquelles peuvent être déplacées l'une par rapport à l'autre en fonction d'un actionnement de l'élément de commande (3), et une valeur d'un paramètre physique peut être acquise par l'unité de mesure (6, 6') en fonction d'un écart (A) de la première électrode (7) et de la deuxième électrode (8) l'une par rapport à l'autre et l'appareil (5) peut être commandé en fonction de la valeur, l'arrangement de commande (3) possédant un élément de couplage (11) qui est couplé en mouvement avec l'élément de commande (4) et avec la première électrode (7), et l'arrangement de commande (3) possédant une plaque porteuse (9) sur laquelle est configurée la deuxième électrode (8), et un contact de mise à la terre (31) d'une liaison de mise à la terre (32) destinée à relier la première électrode (7) à la terre étant configuré sur la plaque porteuse (9), la liaison de mise à la terre (32) possédant un élément ressort (33) séparé du contact de mise à la terre (31), lequel est mis en contact respectivement à la fois avec le contact de mise à la terre (31) et la première électrode (7) avec les écarts (A) différents qui se produisent entre les électrodes (7, 8) en raison des mouvements relatifs, **caractérisé en ce que** l'élément de commande (4) et l'élément de couplage (11) sont des éléments structuraux séparés, qui sont reliés mécaniquement et l'arrangement de commande (3) possède un dispositif de réglage (19) par lequel peut être modifiée la position relative entre l'élément de commande (4) et l'élément de couplage (11), de sorte que la force nécessaire pour actionner l'arrangement de commande est réglable.

2. Arrangement de commande (3) selon la revendication 1, **caractérisé en ce que** la plaque porteuse est réalisée sous la forme d'un circuit imprimé (9) de l'arrangement de commande (3).

3. Arrangement de commande (3) selon l'une des revendications précédentes, **caractérisé en ce que** l'élément ressort (33) est disposé de manière périphérique autour de l'élément de couplage (11).

4. Arrangement de commande (3) selon l'une des revendications précédentes, **caractérisé en ce que** l'élément ressort (33) est réalisé sous la forme d'un ressort hélicoïdal.

5. Arrangement de commande (3) selon l'une des revendications précédentes, **caractérisé en ce que** la deuxième électrode (7) est configurée de manière périphérique autour du contact de mise à la terre (31).

6. Arrangement de commande (3) selon la revendication 4, **caractérisé en ce que** le contact de mise à la terre (31) est entouré par la deuxième électrode (8).

7. Arrangement de commande (3) selon l'une des revendications précédentes, **caractérisé en ce que** l'élément de couplage (11) s'étend à travers un trou (12) dans la plaque porteuse (9) et est relié à demeure avec la première électrode (7) et est couplé mécaniquement à l'élément de commande (4) par une première extrémité d'élément de couplage (13).

8. Arrangement de commande (3) selon l'une des revendications précédentes, **caractérisé en ce qu'**au moins l'une des deux électrodes (7, 8) possède une couche isolante (10) sur le côté supérieur faisant face à l'autre électrode (7, 8) .

9. Arrangement de commande (3) selon l'une des revendications précédentes, **caractérisé en ce que** la deuxième électrode (8) est intégrée dans la plaque porteuse (9).

10. Arrangement de commande (3) selon l'une des revendications précédentes, **caractérisé en ce que** la première électrode (7) est configurée en forme de pot et possède une coupelle d'électrode (34') à une première extrémité (21) de la première électrode (7).

11. Arrangement de commande (3) selon l'une des revendications précédentes, **caractérisé en ce que** l'élément ressort (33) repose contre un côté inférieur (35) d'une tête d'élément de couplage (36).

12. Arrangement de commande (3) selon l'une des revendications précédentes, **caractérisé en ce que** l'élément ressort (33) repose contre une plateforme (37) d'une zone de positionnement de l'élément de couplage (11) .

13. Arrangement de commande (3) selon l'une des revendications précédentes, **caractérisé en ce que** l'élément ressort (33), vu sur toute son étendue dans la direction d'un axe longitudinal (L) de l'élément ressort (33), est entouré par la première électrode (7).

14. Véhicule automobile (1) comprenant un arrangement de commande (3) selon l'une des revendications 1 à 13.
